# EUROPEAN PATENT APPLICATION

(11) **EP 0 813 234 A2**
(43) Date of publication of application: **17.12.1997**
(21) Application number: 97109395.0
(22) Date of filing: 10.06.1997
(51) Int. Cl.: H01L 21/336, H01L 21/225, H01L 21/285

(54) **Method of manufacturing a MOSFET**

(30) Priority: 12.06.1996 US 19625 P
(71) Applicant: TEXAS INSTRUMENTS INCORPORATED, Dallas Texas 75265 (US)
(72) Inventor: Hu, Jerry Che-Jen, Dallas, TX 75243 (US); Hong, Qi-Zhong, Dallas, TX 75243 (US); Hsia, Steve, Plano, TX 75025 (US); Chen, Ih-Chin, Richardson, TX 75082 (US)
(74) Representative: Schwepfinger, Karl-Heinz, Dipl.-Ing.

(57) **Abstract**

A method for forming a ultra-shallow junction region (104). A silicon film (single crystalline, polycrystalline or amorphous) is deposited on the substrate (100) to form an elevated S/D (106). A metal film is deposited over the silicon film and reacted with the silicon film to form a silicide film (108). The silicon film is preferably completely consumed by the silicide film formation. An implant is performed to implant the desired dopant either into the metal film prior to silicide formation or into the silicide film after silicide formation. A high temperature anneal is used to drive the dopant out of the silicide film to form the junction regions (104) having a depth in the substrate (100) less than 200A. This high temperature anneal may be one of the anneals that are part of the silicide process or it may be an additional process step.

## Description

### FIELD OF THE INVENTION

This invention generally relates to semiconductor devices, and more specifically to the formation of ultra-shallow junction regions for sub-micron devices.

### BACKGROUND OF THE INVENTION

As device geometries continue to shrink, the formation of an ultra shallow junction for the source and drain (S/D) regions of a MOSFET transistor becomes more important. These ultra-shallow junctions must maintain low sheet resistance and low junction leakage. A S/D junction depth shallower than 500Å is needed when the gate length is shrunk down to less than 0.1 µm in order to prevent degradation of the device performance due to short channel effects (SCE).

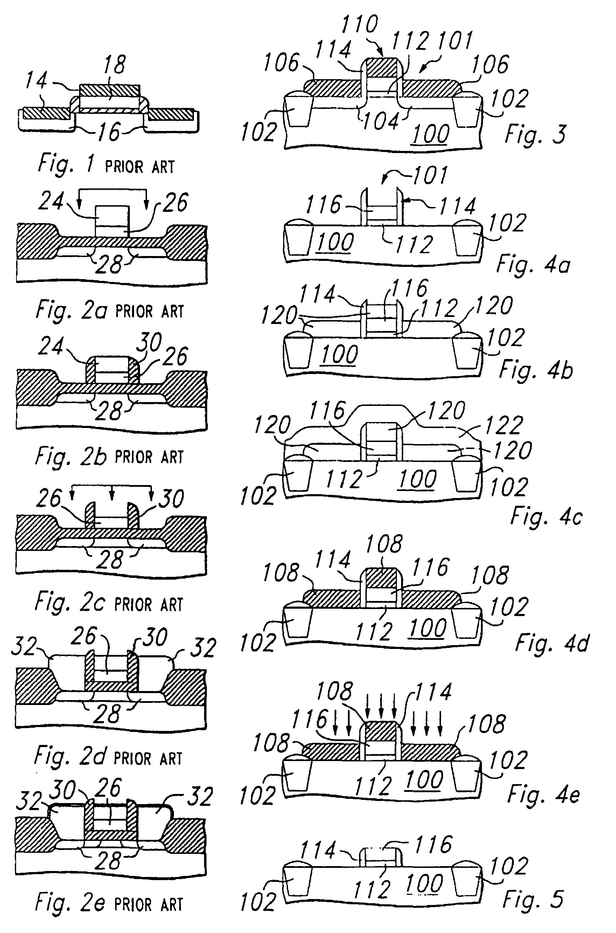

One prior art method for forming shallow junctions is to use Silicide as a Diffusion Source (SADS). In this method, a layer of cobalt is formed over the structure by evaporation/sputtering. The cobalt layer is formed to a thickness of 12.5 nm. Then, a rapid thermal anneal RTA is performed at approximately 500°C for around 20 seconds in a nitrogen ambient to form cobalt-silicide and a selective cobalt etch is performed to remove any unreacted cobalt. This is followed by a second RTA at approximately 800°C for around 10 sec in a nitrogen ambient. The silicide is then implanted with the desired dopant. A third RTA is then used to drive the dopant out of the silicide to form the junction region. FIG. 1 illustrates the resulting device structure. The diffusion from the silicide layer 14 creates the junction regions 16. A portion of silicide layer 14 also exists over the gate electrode 18. There are several advantages to SADS. First, the implantation damage is confined to the silicide region. This can retard transient enhanced diffusion (TED) of dopants caused by the implantation damage and helps to form a shallow junction. Second, since the junction is diffused from the silicide layer, the junction contour follows the silicide contour. In this way, localized high field effects can be avoided and the minimum distance between silicide and metallurgical junction can be decreased. For example, this distance can be as small as 100-150Å with the junction still showing good leakage behavior. On the other hand, for conventional processes with silicide formed after junction formation, the distance of 900Å is required for 450Å of silicide to ensure good leakage behavior. The disadvantage of the conventional SADS is that while the distance between the silicide and metallurgical junction can be small, the total junction depth into the substrate including the silicide thickness and the diffusion depth cannot. Forming a total junction depth less than 600Å is very hard to achieve without losing sheet resistance and good junction leakage behavior. This is due to the fact that when the silicide layer is too thin (<400Å), agglomeration of the silicide under high temperature steps can significantly degrade the sheet resistance and the junction integrity of the film.

Another method of forming shallow junctions uses an elevated source and drain (ESD). FIGs. 2a-2e show a typical process flow for ESD. Referring to FIG. 2a, using a nitride mask 24 over the polysilicon gate 26, the source/drain implant is performed creating implanted regions 28. Next, the sidewall spacers 30 are formed as shown in FIG. 2b. The nitride mask 24 is then removed and a channel implant is performed as shown in FIG. 2c. Next, a selective polycrystalline silicon layer is deposited on the substrate to form the elevated S/D 32 as shown in FIG. 2d. Finally, the elevated S/D 32 and polysilicon gate 26 are silicided as shown in FIG. 2e. The ESD is used only to decrease the junction depth of the deep S/D. For a conventional device structure, since silicide is formed over the deep S/D after junction formation, a junction depth of 1300Å is necessary to prevent leakage problems caused by silicide spikes. By using the ESD process at deep S/D, the junction depth below the silicon substrate surface can be greatly reduced while maintaining good electrical reliability and a low sheet resistance for the deep S/D. Although ESD can improve device performance, there are some problems that need to be resolved. For example, as device dimensions shrink, the junction depth at S/D extension is much more critical than deep S/D for SCE. A traditional ESD does not address the issue of shallow S/D extension formation. Also, for conventional ESD, in order to form a junction depth of 200Å, the thickness of the deposited polycrystalline silicon film needs to be approximately 1000Å in order to prevent any reliability problems caused by silicide spikes into the junction.

### SUMMARY OF THE INVENTION

A method for forming an ultra-shallow junction region is described herein. A silicon film is deposited on the substrate to form an elevated S/D. A metal film is deposited over the silicon film and reacted with the silicon film to form a silicide film. The silicon film is preferably completely consumed by the silicide film formation. An implant is performed to implant the desired dopant either into the metal film prior to silicide formation or into the silicide film after silicide formation. A high temperature anneal is used to drive the dopant out of the silicide film to form the junction regions. This high temperature anneal may be one of the anneals that are part of the silicide process or it may be an additional process step.

An advantage of the invention is providing an ultra-shallow junction region having depth less than 200Å.

A further advantage of the invention is providing an ultra-shallow junction region having a depth less than 200Å with low sheet resistance and good leakage behavior.

A further advantage of the invention is providing a reduced thickness elevated S/D in conjunction with an ultra-shallow junction region.

### BRIEF DESCRIPTION OF THE DRAWINGS

The present invention will now be further described, by way of example, with reference to the accompanying drawings in which:-
FIG. 1 is a cross-sectional diagram of a prior art transistor formed by silicide as a diffusion source process;
FIGs. 2a-2e are cross-sectional diagrams of a prior art elevated S/D process;
FIG. 3 is a cross-sectional diagram of a transistor formed according to the invention;
FIGs. 4a-e are cross-sectional diagrams of the transistor of FIG. 3 at various stages of fabrication; and
FIGs. 5 is a cross-sectional diagram of an alternative sidewall spacer configuration for the invention.

Corresponding numerals and symbols in the different figures refer to corresponding parts unless otherwise indicated.

### DETAILED DESCRIPTION OF PREFERRED EMBODIMENTS

The invention will now be described in conjunction with forming a shallow junction for the source and drain regions of a MOSFET transistor. The invention is, however, applicable to forming shallow junctions in general and is not intended to be limited to the transistor structure described below.

A MOSFET transistor 101 having ultra-shallow S/D junction regions 104 formed according to the invention is shown in FIG. 3. Transistor 101 is formed in semiconductor body/substrate 100 and is isolated from other transistors (not shown) by field oxide regions 102. Other types of isolation techniques, such as trench isolation are well known in the art and may alternatively be used. As is conventional, transistor 101 includes a gate electrode 110 separated from the semiconductor body 100 by gate dielectric region 112. The composition of gate electrode 110 is not critical to the invention, and may, for example, comprise a polysilicon portion with an overlying silicide portion. Sidewall spacers 114 are located adjacent gate electrode 110.

Transistor 101 also includes an elevated S/D 106. Elevated S/D 106 comprises a silicide material such as cobalt-silicide, titanium-silicide, or tungsten-silicide located directly on the semiconductor body 100. This is different from prior art elevated S/D structures in which only the upper surface of the elevated S/D is silicide with the remaining portion of the elevated S/D structure remaining an epitaxial silicon film. Elevated S/D 106 are also thinner than prior art elevated S/D regions because the problem of silicide spiking into the underlying junction region is not a concern because S/D junction regions 104 are diffused from elevated S/D 106 after silicide formation and thus will follow the silicide contour. This will be explained in more detail below. S/D junction regions 104 have a depth in semiconductor body 100 preferably less than 200Å. Accordingly, S/D junction regions 104 may be used in transistors having a gate linewidth as small as 0.1µm while maintaining low sheet resistance and low leakage current.

A method for forming transistor 101 according to the invention will now be described in conjunction with FIGs. 4a-4e. FIG. 4a illustrates transistor 101 processed through the formation of sidewall spacer 114. A dummy mask, such as a nitride mask, may have been used to create sidewall spacers 114 that extend above the surface of gate layer 116. Alternatively, however, sidewall spacers 114 may only extend to even with the surface of gate layer 116 as shown in FIG. 5. Gate layer 116 typically comprises polysilicon, but other conductive materials may also be used. It should be noted that LDD (lightly doped drain) extension regions have not been formed prior to this point as they might have been in a conventional process.

Referring to FIG. 4b, a layer of silicon 120 is selectively formed over the exposed portions of semiconductor body 100 and gate layer 116 (if it comprises polysilicon). The silicon layer 120 may, for example, be single crystalline silicon, polycrystalline silicon or amorphous silicon. Silicon layer 120 is deposited to a thickness on the order of 100 Å to 1000 Å. The preferred range is 350-500 Å. During a silicide process, spikes of silicide may be created that extend downward into the structure. In prior art processes where the silicide is formed after the junction, there must be enough distance between the silicide and the junction bottom to avoid creating a spike that extends deeper than the junction depth. Otherwise, unacceptably high leakage may occur. As a result, prior art elevated S/D processes typically required an epitaxial silicon thickness on the order of 1000Å in order to avoid adversely impacting device performance due to silicide spikes.

Next, a layer of refractory metal 122 is deposited over the structure as shown in FIG. 4c. Refractory metal layer 122 preferably comprises cobalt, but may comprise other refractory metals such as titanium and tungsten. The thickness of refractory metal layer 122 is determined by the silicide process technology. It is desirable for all of the silicon layer 120 to be consumed during the subsequent silicide process. Preferably, the silicon layer 120/semiconductor body 100 interface is also consumed during the subsequent silicide process. The thickness of silicon layer 120 and refractory metal layer 122 are chosen such that the subsequently formed silicide/semiconductor body interface is at the same depth or less than the depth of the gate oxide/semiconductor body interface. The refractory metal layer 120 is chosen according to the above constraints. For example, using cobalt, a refractory metal layer thickness on the order of the thickness of the silicon layer 120 is desired (e.g. approx. 100-500Å).

The refractory metal layer 122 is then reacted with the silicon layer 120 to form silicide layer 108, as shown in FIG. 4d. This may occur in either a furnace or a rapid thermal process (RTP). Preferably, an RTP at a temperature of the order of 550°C in a nitrogen ambient for 30 sec is used for the reaction. Refractory metal silicide 108 is formed over silicon containing materials such as the silicon layer 120. Refractory metal may also react with the nitride ambient to form refractory metal-nitride. Some unreacted refractory metal may also remain. Any remaining unreacted refractory metal and any refractory metal-nitride are then selectively removed. An anneal is then performed to reduce the resistance of the refractory metal-silicide. For example, an RTP at a temperature in the range of 700-900°C for 10-30 sec in a nitrogen ambient may be used.

If desired, a selective chemical vapor deposition (CVD) of silicide may be used to form silicide layer 108 instead of the process described above. If selective CVD of silicide is performed, the steps of forming a layer of silicon 120, depositing a layer of refractory metal 122, and reacting the layer of refractory metal 122 with silicon layer 120 and annealing to form silicide layer 108 may be omitted.

Referring to FIG. 4e, a selective implant of the desired dopant is implanted into the silicide layer 108, regardless of the manner in which silicide layer 108 is formed. In a CMOS process, a n-type dopant is used for the n-type transistors and a p-type dopant is used for the p-type transistors. An anneal is then performed to drive the dopant out of the silicide layer 108 to form S/D junction regions 104, as shown in FIG. 3. For example, an RTP at a temperature in the range of 750-950°C for 10-20 seconds in a nitrogen ambient may be used. This creates a junction depth less than 200Å into the semiconductor surface.

Alternatively, the implant may be performed prior to the silicide process. In this case, the dopant is implanted into the refractory-metal layer 122. The react step of the silicide process is then used to drive the dopant into the semiconductor body. The implant may alternatively be performed just prior to the anneal step of the silicide process after the refractory metal-nitride and any unreacted refractory metal has been removed. The anneal step of the silicide process is then used to drive the dopant into the semiconductor body to form junction regions 104. In both of these cases, the third heat treatment (i.e., the anneal described above as occurring after the silicide process) may be omitted because the junction regions are formed during one of the heat treatment processes of the silicide process.

Implanting into the silicide layer 108 or refractory metal layer 122 instead of directly into the semiconductor body has several advantages. First, the implant damage occurs in the silicide layer 108 or refractory metal layer 122 rather than in the junction region. As a result, TED (transient enhanced diffusion) is suppressed. Second, because the implant damage occurs in the refractory metal layer 122 or silicide layer 108, a lower temperature anneal may be used to anneal out the implant damage. A lower temperature anneal results in a shallower junction depth.

Moreover, since the junction 104 is formed after the silicide layer 108, the thickness of the deposited silicon layer 120 can be significantly less than a conventional elevated S/D process. This is due to the fact that the junction region is diffused from the silicide layer 108 including any silicide spikes that are created. Therefore, the spikes cannot extend past the junction depth and do not cause additional leakage. Also the stopping power of a dopant in silicide is larger than that in silicon. As a result, under the same implant energy, a thinner silicide film is sufficient for the implanted dopants to be confined in the silicide film 108. This also decreases the effect of implant damage on junction leakage and junction depth. In addition, the interface between the semiconductor body and the silicon layer 120 is less critical than in prior art elevated S/D process because the interface can be consumed during the silicide process which can remove any residual oxide at the interface. This helps to reduce the sheet resistance and contact resistance of the source and drain.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method for forming a shallow junction region in a semiconductor body, comprising the steps of:
forming a silicide film on said semiconductor body;
implanting said silicide film with a dopant;
annealing said silicide film to diffuse said dopant into said semiconductor body to form said shallow junction region.

2. The method of Claim 1, wherein said step of forming a silicide film further comprises the steps of:
forming a silicon film on said semiconductor body;
forming a refractory metal layer on said silicon film; and
reacting said refractory metal layer with said silicon film to form said silicide film.

3. The method of Claim 1 or Claim 2, further comprising the step of annealing said silicide film prior to said implanting step.

4. The method of Claim 2 or Claim 3, wherein said step of forming said silicon film comprises forming a polycrystalline silicon film.

5. The method of Claim 2 or Claim 3, wherein said step of forming said silicon film comprises forming an amorphous silicon film.

6. The method of Claim 2 or Claim 3, wherein said step of forming said silicon film comprises forming a single crystalline silicon film.

7. The method of any of Claims 2 to 6, wherein said step of forming said refractory metal layer comprises forming a refractory metal layer comprising cobalt.

8. The method of any of Claims 2 to 7, wherein said step of forming said silicon film comprises forming said silicon film to a thickness of the order of 350-500 Angstroms.

9. The method of any of Claims 2 to 8, wherein said step of forming said refractory metal layer comprises forming said refractory metal layer to a thickness of the order of 100-200 Angstroms.

10. The method of any of Claims 2 to 9, wherein said reacting step consumes all of said silicon film.

11. The method of any of Claims 2 to 10, wherein said reacting step consumes an interface between said silicon film and said semiconductor body.

12. The method of any preceding claim, wherein said step of forming said silicide film comprises the step of selectively depositing silicide using selective chemical vapor deposition.

13. The method of any preceding claim, wherein said forming implanting and annealing steps are performed such that said junction region is diffused to a depth less than 200 Angstroms.

14. A method of forming a shallow S/D junction region in a semiconductor body, comprising the steps of:
forming a silicon film having a thickness less than 500 Å on said semiconductor body;
forming a refractory metal layer on said silicon film;
reacting said refractory metal layer with said silicon film to form a silicide film that consumes all of said silicon film;
implanting said silicide film with a dopant;
annealing said silicide film to diffuse said dopant into said semiconductor body to a depth in said semiconductor body less than 200 Å to form said shallow S/D junction region.

15. A method for forming a shallow junction region in a semiconductor body, comprising the steps of:
forming a silicon film on said semiconductor body;
forming a refractory metal layer on said silicon film;
implanting said refractory metal layer with a dopant;
reacting said refractory metal layer with said silicon film to form a silicide film;
annealing said silicide film to diffuse said dopant into said semiconductor body to form said shallow junction region.

16. The method of Claim 15, wherein said step of forming said silicon film comprises forming a polycrystalline silicon film having a thickness less than 500 Angstroms.

17. The method of Claim 15, wherein said step of forming said silicon film comprises forming an amorphous silicon film having a thickness less than 500 Angstroms.

18. The method of any of Claims 15 to 17, wherein said reacting step consumes an interface between said silicon film and said semiconductor body.

19. The method of any of Claims 15 to 18, further comprising diffusing said junction region to a depth less than 200 Angstroms.

20. A MOSFET transistor, comprising:
a source diffused region and a drain diffused region located in a semiconductor body;
an elevated source region and an elevated drain region comprising a silicide material located on said source diffused region and drain diffused regions, respectively;
a gate oxide layer located between said elevated source region and said elevated drain region; and
a gate electrode located over said gate oxide layer.

21. The MOSFET transistor of Claim 20, wherein said source diffused region and said drain diffused region each have a depth in said semiconductor body less than 200 Angstroms.

22. The MOSFET transistor of Claim 20 or Claim 21, wherein said silicide material comprises cobalt-silicide.
